# EUROPÄISCHE PATENTSCHRIFT

(11) **EP 2 622 660 B1**
(45) Veröffentlichungstag und Bekanntmachung des Hinweises auf die Patenterteilung: **03.05.2017**
(21) Anmeldenummer: 11760797.8
(22) Anmeldetag: 27.09.2011
(51) Int. Cl.: H01L 41/053, H01L 41/083, H01L 41/23, H01L 41/257

(54) **PIEZOELEKTRISCHES VIELSCHICHTBAUELEMENT UND VERFAHREN ZU DESSEN HERSTELLUNG**
PIEZOELECTRIC MULTILAYER COMPONENT AND METHOD FOR PRODUCING SAME
COMPOSANT PIÉZOÉLECTRIQUE MULTICOUCHE ET PROCÉDÉ DE FABRICATION DUDIT COMPOSANT PIÉZOÉLECTRIQUE MULTICOUCHE

(30) Priorität: 01.10.2010 DE 102010047302
(43) Veröffentlichungstag der Anmeldung: 07.08.2013
(73) Patentinhaber: Epcos AG, 81669 Munich (DE)
(72) Erfinder: GALLER, Martin, verstorben (AT)
(74) Vertreter: Epping - Hermann - Fischer
(86) Internationale Anmeldenummer: PCT/EP2011/066771
(87) Internationale Veröffentlichungsnummer: WO 2012/041854

(56) Entgegenhaltungen:
- EP-A2- 1 381 094
- EP-A2- 1 808 906
- DE-A1- 10 021 919
- YUE Z ET AL: "Effects of Ag-Pd powder on ferroelectric and mechanical properties of PLZT ceramics", KEY ENGINEERING MATERIALS, Bd. 280-283, 2005, Seiten 151-154, XP009141653,

## Beschreibung

Die vorliegende Erfindung betrifft ein piezoelektrisches Vielschichtbauelement, das mit einer Passivierung versehen ist, die die Lebensdauer des Bauelementes auch bei mechanischer Beanspruchung wirkungsvoll verlängert.

Piezoelektrische Vielschichtbauelemente, insbesondere Multilagen-Piezoaktuatoren, sind als Abfolge piezoelektrischer Keramikschichten und metallischer Innenelektroden, im Folgenden als Piezostapel bezeichnet, aufgebaut. Bei einer herkömmlichen Ausgestaltung reichen die Innenelektroden bis zu einer Oberfläche des Bauelementes, so dass es an der Außenseite des Piezostapels infolge der üblicherweise auftretenden hohen elektrischen Feldstärken (typisch 2 kV/mm) zu elektrischen Überschlägen zwischen Innenelektroden, die auf unterschiedlichem elektrischem Potenzial liegen, kommen kann. Um das zu vermeiden, wird der Piezostapel mit einer Passivierung versehen, die insbesondere eine Umhüllung des Piezostapels bilden kann. Die Durchschlagsfestigkeit des Materials der Passivierung muss größer sein als die auftretenden elektrischen Feldstärken, und diese Eigenschaft muss für alle Betriebszustände des Bauelementes über die gesamte Einsatzdauer hinweg erhalten bleiben. Außerdem sollte die Passivierung das Bauelement gegen Einflüsse von außen (zum Beispiel gegen eindringende Substanzen) schützen. Der Betrieb des Piezoaktuators stellt zudem hohe Anforderungen an die mechanischen Eigenschaften der Passivierung.

Eine Passivierung mit den geforderten Eigenschaften kann aus keramischem Material hergestellt werden, das eine hohe Durchschlagsfestigkeit aufweist und einen guten Schutz des Piezostapels gegen äußere Einflüsse bietet. Damit die geforderten Eigenschaften erhalten bleiben, ist es wichtig, dass die Passivierung im Betrieb des Bauelementes nicht beschädigt wird und keine Risse bekommt.

Der Piezostapel wird bei der Herstellung des Bauelementes polarisiert, um ihm eine remanente Polarisation einzuprägen. Daraus resultiert eine Dehnung des Piezostapels. Im Betrieb eines Piezoaktuators wird der Piezostapel nochmals gedehnt. Wegen der festen Verbindung zwischen der Passivierung und dem Piezostapel werden die Dehnungen des Piezostapels auf die Passivierung übertragen, so dass darin eine Zugspannung aufgebaut wird. Wenn die Zugspannung einen Grenzwert überschreitet, bilden sich Risse in der Passivierung.

Wenn als Passivierung dasselbe keramische Material vorgesehen wird wie für die Keramikschichten des Piezostapels, wird die Passivierung während der Polarisierung des Piezostapels durch die an den Kanten der Innenelektroden auftretenden elektrischen Streufelder ebenfalls polarisiert. Das bewirkt, dass die Passivierung im Betrieb des Piezoaktuators zusammen mit dem Piezostapel gedehnt wird - allerdings nicht so stark wie der Piezostapel - und die in der Passivierung aufgebaute Zugspannung geringer ist als ohne Dehnung der Passivierung. Eine Voraussetzung hierfür ist, dass die Passivierung nur etwa höchstens so dick ist wie eine einzelne Keramikschicht des Piezostapels und daher ausreichend polarisiert werden kann. Der durch die Passivierung bewirkte Schutz kann wegen der geringen Dicke jedoch unzureichend sein.

In der EP 1 808 906 A2 ist ein Piezoaktor beschrieben, der mit einer Ummantelung aus der Piezokeramik des keramischen Grundkörpers versehen ist. Die Ummantelung ist mit dem Metall der Innenelektroden dotiert, um eine möglichst weitgehende Übereinstimmung der Materialien des keramischen Grundkörpers und der Ummantelung zu erreichen.

In der EP 1 381 094 A2 ist eine Isolierschicht auf einem piezokeramischen Vielschichtaktor beschrieben. Für die Isolierschicht wird eine Paste aus einem anorganischen, niedrig sinternden Material, das insbesondere ein mit dem Aktormaterial identisches Material sein kann, und einem organischen Bindersystem mittels eines Dickschichtverfahrens aufgebracht.

In der DE 100 21 919 A1 ist ein Herstellungsverfahren für piezokeramische Vielschichtaktoren angegeben, die mit einer grünen Keramikfolie umhüllt werden. Die Umhüllung wird ebenso wie die übrige Keramik polarisiert.

In der Veröffentlichung von Z. Yue et al. mit dem Titel "Effects of Ag-Pd Powder on Ferroelectric and Mechanical Properties of PLZT Ceramics" in Key Engineering Materials Vols. 280-283 (2005), Seiten 151-154, ist angegeben, dass das Einbringen von Ag-Pd-Teilchen in eine PLZT-Keramik deren Polarisation und Koerzitivfeldstärke vermindert.

Aufgabe der vorliegenden Erfindung ist es, eine Möglichkeit anzugeben, wie ein piezoelektrisches Vielschichtbauelement wirkungsvoll gegen Rissbildung und äußere Einflüsse geschützt werden kann.

Diese Aufgabe wird mit dem piezoelektrischen Vielschichtbauelement mit den Merkmalen des Anspruches 1 beziehungsweise mit dem Verfahren zur Herstellung eines piezoelektrischen Vielschichtbauelementes mit den Merkmalen des Anspruches 5 gelöst. Ausgestaltungen ergeben sich aus den abhängigen Ansprüchen.

Das piezoelektrische Vielschichtbauelement weist einen Piezostapel mit einer alternierenden Abfolge von piezoelektrischen Keramikschichten und Innenelektroden sowie eine Passivierung auf einer Außenseite auf. Das Material der Passivierung ist eine piezoelektrische Keramik und von dem Material der Keramikschichten des Piezostapels verschieden.

Bei Ausführungsbeispielen des Bauelementes weist die Keramik der Passivierung eine geringere elektrische Koerzitivfeldstärke auf als die Keramikschichten des Piezostapels. Die elektrische Koerzitivfeldstärke ist diejenige elektrische Feldstärke, die nötig ist, um eine Polarisation eines Ferroelektrikums zu beseitigen. Je größer die elektrische Koerzitivfeldstärke ist, desto besser behält das Ferroelektrikum seine Polarisation und die damit bewirkte piezoelektrische Eigenschaft. Ein Material mit einer niedrigen elektrischen Koerzitivfeldstärke lässt sich leichter polarisieren als ein Material mit einer höheren elektrischen Koerzitivfeldstärke.

Die von den Rändern der Innenelektroden ausgehenden elektrischen Streufelder nehmen mit zunehmendem Abstand von den Innenelektroden stark ab. Wenn für die Passivierung ein Material geringer elektrischer Koerzitivfeldstärke verwendet wird, kann die Passivierung auch in größerem Abstand von den Innenelektroden durch die relativ schwachen elektrischen Streufelder polarisiert werden. Dadurch wird auch bei einer relativ dicken Passivierung eine durchgehende Polarisation erreicht, und die Passivierung wird im Betrieb des Bauelementes ähnlich stark gedehnt wie der Piezostapel. Eine Passivierung aus einem derartigen Material darf deshalb wesentlich dicker sein als eine einzelne Keramikschicht des Piezostapels. Eine dickere Passivierung bietet einen entsprechend besseren Schutz. Außerdem lässt sich eine dickere Passivierung einfacher herstellen.

Bei weiteren Ausführungsbeispielen ist die Keramik der Passivierung so beschaffen, dass sie durch Polarisieren stärker gedehnt wird und aufgrund der remanenten Polarisation eine stärkere Dehnung beibehält als das Material der Keramikschichten des Piezostapels unter gleichen Bedingungen der Polarisierung, insbesondere derselben polarisierenden elektrischen Feldstärke. Da die Passivierung fest mit dem Piezostapel verbunden ist und sich nicht stärker dehnt als der Piezostapel, wird bei der gemeinsamen Polarisierung eine in der Längsrichtung des Bauelementes wirkende Druckspannung in der Passivierung aufgebaut. Eine Zugspannung, die in der Passivierung entsteht, wenn der Piezostapel im Betrieb des Bauelementes in der Längsrichtung gedehnt wird, ist daher um diese Druckspannung vermindert. Eine mechanische Beschädigung der Passivierung kann dadurch vermieden werden. Bei diesen Ausführungsbeispielen weist die Passivierung daher in einer durch die Abfolge von Keramikschichten und Innenelektroden des Piezostapels definierten Längsrichtung eine Druckspannung auf, die aufgrund der festen Verbindung der Passivierung mit dem Piezostapel erhalten bleibt und eine Zugspannung, die bei einer Dehnung des Piezostapels in der Längsrichtung auf die Passivierung ausgeübt wird, zumindest teilweise kompensiert.

Bei weiteren Ausführungsbeispielen weist die Passivierung eine Dicke auf, die größer ist als das Eineinhalbfache der Dicke einer einzelnen der Keramikschichten des Piezostapels.

Bei dem Verfahren zur Herstellung eines piezoelektrischen Vielschichtbauelementes wird ein Piezostapel, der eine alternierende Abfolge von piezoelektrischen Keramikschichten und Innenelektroden aufweist, mit einer Passivierung versehen, die eine von dem Material der Keramikschichten des Piezostapels verschiedene piezoelektrische Keramik aufweist. Die Passivierung wird zusammen mit den Keramikschichten des Piezostapels polarisiert.

Bei Ausgestaltungen des Verfahrens wird für die Passivierung eine Keramik verwendet, die eine geringere elektrische Koerzitivfeldstärke aufweist als das Material der Keramikschichten des Piezostapels. Wenn die Passivierung zusammen mit den Keramikschichten des Piezostapels polarisiert wird, wird der Passivierung durchgehend eine Polarisation eingeprägt.

Bei weiteren Ausgestaltungen des Verfahrens wird die Keramik der Passivierung so gewählt, dass sie bei Einprägen einer Polarisation stärker als der Piezostapel gedehnt wird. Die Passivierung wird mit dem Piezostapel fest verbunden, und die Passivierung wird in der durch die alternierende Abfolge von piezoelektrischen Keramikschichten und Innenelektroden definierten Längsrichtung des Piezostapels mit einer Druckspannung versehen, wenn die Passivierung zusammen mit den Keramikschichten des Piezostapels polarisiert wird.

Bei weiteren Ausgestaltungen des Verfahrens wird die Passivierung in einer Dicke hergestellt, die größer ist als das Eineinhalbfache der Dicke einer einzelnen der Keramikschichten des Piezostapels.

Es folgt eine genauere Beschreibung von Beispielen des piezoelektrischen Vielschichtbauelementes und des Herstellungsverfahrens anhand der beigefügten Figuren.
Die Figur 1 zeigt eine perspektivische Ansicht eines piezoelektrischen Vielschichtbauelementes.
Die Figur 2 zeigt einen Ausschnitt aus einem Querschnitt durch ein Vielschichtbauelement gemäß der Figur 1.

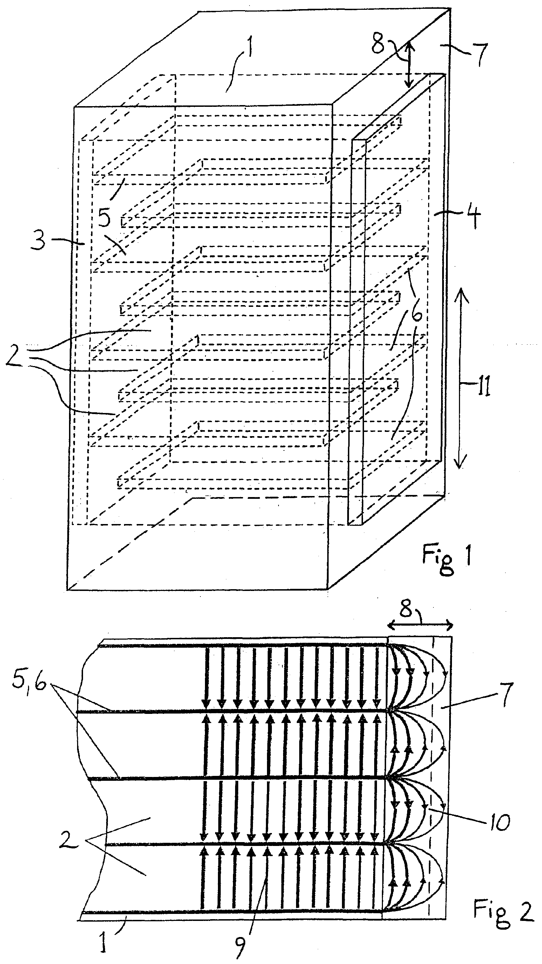

Die Figur 1 zeigt ein piezoelektrisches Vielschichtbauelement mit einem Piezostapel 1, der aus piezoelektrischen Keramikschichten 2 aufgebaut ist. Zwischen zwei in dem Piezostapel 1 aufeinander folgenden Keramikschichten 2 ist jeweils eine Innenelektrode 5, 6 angeordnet, so dass der Piezostapel 1 eine alternierende Abfolge aus Keramikschichten 2 und Innenelektroden 5, 6 enthält. Die Innenelektroden 5, 6 sind in ihrer Abfolge abwechselnd mit je einer von zwei Außenelektroden 3, 4 verbunden. In dem dargestellten Beispiel der Figur 1 befindet sich eine erste Außenelektrode 3 auf einer Außenseite des Piezostapels 1 und eine zweite Außenelektrode 4 auf der gegenüberliegenden Außenseite des Piezostapels 1. Statt dessen sind andere Ausgestaltungen möglich; insbesondere können die Außenelektroden 3, 4 zum Beispiel um die jeweiligen Kanten des Piezostapels 1 herumgezogen sein. Außerdem können weitere Außenelektroden vorgesehen werden.

Die in der Figur 1 dargestellte Anordnung ist insbesondere zweckmäßig für einen Piezoaktuator, der im Betrieb in der Längsrichtung 11, die durch die alternierende Abfolge der Keramikschichten 2 und Innenelektroden 5, 6 bestimmt ist, gedehnt wird. Bei der Herstellung eines solchen Bauelementes werden die Keramikschichten 2 des Piezostapels 1 polarisiert. Dadurch wird den Keramikschichten 2 eine remanente Polarisation eingeprägt, deren Richtung sich von einer Keramikschicht 2 zu der nächsten Keramikschicht 2 jeweils umkehrt. Eine Passivierung 7 mit einer Dicke 8 bedeckt zumindest einen Anteil der Außenseiten des Piezostapels 1, in dem Beispiel der Figur 1 sämtliche nicht von den Außenelektroden 3, 4 bedeckten Außenseiten des Piezostapels 1. Bei Verwendung einer geeigneten piezoelektrischen Keramik als Material der Passivierung 7 darf deren Dicke 8 größer sein als die Dicke einer einzelnen Keramikschicht 2 des Piezostapels 1, insbesondere größer als das Eineinhalbfache der Dicke einer einzelnen Keramikschicht 2.

Die Figur 2 zeigt einen Ausschnitt aus einem Querschnitt durch das Bauelement der Figur 1 in einer zu den flächigen Ausdehnungen der Außenelektroden 3, 4 koplanaren Ebene. In der Figur 2 sind fünf der Innenelektroden 5, 6 dargestellt, die zwischen Keramikschichten 2 des Piezostapels 1 angeordnet sind. Die Außenelektroden 3, 4 befinden sich in einem Abstand zu der Ebene des Querschnitts vor und hinter der Zeichenebene. Die Figur 2 zeigt auch einen Ausschnitt des Querschnitts durch die auf einer Außenseite des Piezostapels 1 angeordneten Passivierung 7 mit der Dicke 8. Das bei der Polarisierung des Piezostapels 1 und im Betrieb des Bauelementes erzeugte elektrische Feld 9 ist mit den vertikal ausgerichteten parallelen Pfeilen angedeutet. Die gebogenen Pfeile innerhalb des Querschnitts der Passivierung 7 deuten das seitliche Streufeld an. Wenn für die Passivierung 7 dasselbe keramische Material wie für die Keramikschichten 2 des Piezostapels 1 verwendet wird, kann eine wirkungsvolle remanente Polarisation der Passivierung 7 zum Beispiel nur bis zu der gestrichelten Linie erreicht werden. Wenn für die Passivierung statt dessen eine piezoelektrische Keramik verwendet wird, die eine deutlich niedrigere elektrische Koerzitivfeldstärke aufweist, wird eine durchgehende Polarisation auch in den von dem Piezostapel 1 am weitesten beabstandeten Bereichen der Passivierung 7 erreicht. Aufgrund der remanenten Polarisation erfährt somit auch die Passivierung 7 durchgehend in ihrer ganzen Dicke 8 eine gewisse Dehnung in der Längsrichtung 11 des Piezostapels 1. Im Inneren der Passivierung 7 möglicherweise auftretende mechanische Spannungen können auf diese Weise vermieden werden oder sind zumindest deutlich geringer als bei Verwendung einer Keramik mit höherer elektrischer Koerzitivfeldstärke.

Ein weiterer Vorteil wird erreicht, wenn das Material der Passivierung 7 so gewählt wird, dass die nach der gemeinsamen Polarisierung der Keramikschichten 2 des Piezostapels 1 und der Passivierung 7 vorhandene remanente Polarisation eine ausreichend große Druckspannung in der Passivierung 7 erzeugt. Eine derartige Druckspannung wird erzeugt, wenn die Materialien so gewählt sind, dass die Dehnung, die aus einer remanenten Polarisation resultiert, die nach einer Polarisierung in dem Material der Passivierung 7 vorhanden ist, größer ist als die Dehnung, die aus einer remanenten Polarisation resultiert, die nach einer Polarisierung mittels derselben elektrischen Feldstärke in dem Material der Keramikschichten 2 vorhanden ist. Da die Passivierung 7 fest mit dem Piezostapel 1 verbunden ist, stimmen die tatsächlichen Dehnungen des Piezostapels 1 und der Passivierung 7 überein, obwohl sie aufgrund der unterschiedlichen Materialeigenschaften verschieden sein müssten. Die durch den Piezostapels 1 erzwungene zu geringe Dehnung der Passivierung 7 ist die Ursache für eine in der Passivierung 7 auftretende Druckspannung, die in der Längsrichtung 11 des Bauelementes wirkt. Wenn der Piezostapel 1 im Betrieb des Bauelementes aufgrund der unterschiedlich starken Polarisation der Keramikschichten 2 und der Passivierung 7, die ja nur durch die seitlichen Streufelder polarisiert wird, stärker gedehnt wird als die Passivierung 7, wird eine dadurch hervorgerufene Zugspannung durch die anfängliche Druckspannung der Passivierung 7 zumindest teilweise kompensiert. Auf diese Weise kann die in der Passivierung 7 auftretende mechanische Spannung unterhalb einer für die mechanische Belastbarkeit des Bauelementes kritischen Grenze gehalten werden.

Ein weiterer Vorteil des piezoelektrischen Vielschichtbauelementes ist, dass das keramische Material der Passivierung 7 unter Berücksichtigung von Eigenschaften optimiert werden kann, die für die Umwandlung einer elektrischen Spannung in einen mechanischen Hub von untergeordneter Bedeutung sind und daher geändert werden können, ohne dass die Funktion des Bauelementes beeinträchtigt wird. Eine auf diese Weise mit piezoelektrischer Keramik ausgebildete Passivierung dient somit wirkungsvoll zur Erhöhung der Robustheit des Bauelementes gegenüber mechanischen Beanspruchungen. Eine derartige Passivierung kann bei verschiedenen Typen piezoelektrischer Vielschichtbauelemente, insbesondere bei Multilagen-Piezoaktuatoren, unabhängig von Design, Material, Ausgestaltung der Innenelektroden, Ausgestaltung der Außenelektroden oder anderer Arten von Außenkontakten und besonderer Eigenschaften des Piezostapels eingesetzt werden, um die Robustheit und Widerstandsfähigkeit des Bauelementes zu verbessern.

### Bezugszeichenliste

- 1: Piezostapel
- 2: Keramikschicht
- 3: erste Außenelektrode
- 4: zweite Außenelektrode
- 5: mit der ersten Außenelektrode verbundene Innenelektrode
- 6: mit der zweiten Außenelektrode verbundene Innenelektrode
- 7: Passivierung
- 8: Dicke
- 9: elektrisches Feld zwischen Innenelektroden
- 10: elektrisches Streufeld am Rand der Innenelektroden
- 11: Längsrichtung

## Patentansprüche

1. Piezoelektrisches Vielschichtbauelement mit
- einem Piezostapel (1), der eine alternierende Abfolge von piezoelektrischen Keramikschichten (2) und Innenelektroden (5, 6) aufweist, und
- einer Passivierung (7) auf einer Außenseite des Piezostapels (1), wobei das Material der Passivierung (7) eine piezoelektrische Keramik und von dem Material der Keramikschichten (2) des Piezostapels (1) verschieden ist,
**dadurch gekennzeichnet, dass**
- die Keramik der Passivierung (7) eine geringere elektrische Koerzitivfeldstärke aufweist als die Keramikschichten (2) des Piezostapels (1) oder so beschaffen ist, dass sie durch Einprägen einer Polarisierung stärker gedehnt wird als das Material der Keramikschichten (2) des Piezostapels (1).

2. Piezoelektrisches Vielschichtbauelement nach Anspruch 1, bei dem die Passivierung (7) durchgehend polarisiert ist.

3. Piezoelektrisches Vielschichtbauelement nach einem der Ansprüche 1 oder 2, bei dem
die Passivierung (7) in einer durch die Abfolge von Keramikschichten (2) und Innenelektroden (5, 6) definierten Längsrichtung (11) des Piezostapels (1) eine Druckspannung aufweist, die aufgrund einer festen Verbindung der Passivierung (7) mit dem Piezostapel (1) erhalten bleibt und eine bei einer Ausdehnung des Piezostapels (1) in der Längsrichtung (11) auf die Passivierung (7) ausgeübte Zugspannung zumindest teilweise kompensiert.

4. Piezoelektrisches Vielschichtbauelement nach einem der Ansprüche 1 bis 3, bei dem
die Passivierung (7) eine Dicke aufweist, die größer ist als das Eineinhalbfache der Dicke einer einzelnen der Keramikschichten (2) des Piezostapels (1).

5. Verfahren zur Herstellung eines piezoelektrischen Vielschichtbauelementes nach einem der Ansprüche 1 bis 4, bei dem
- ein Piezostapel (1), der eine alternierende Abfolge von piezoelektrischen Keramikschichten (2) und Innenelektroden (5, 6) aufweist, mit einer Passivierung (7) versehen wird, die eine von dem Material der Keramikschichten (2) des Piezostapels (1) verschiedene piezoelektrische Keramik aufweist, und
- die Passivierung (7) zusammen mit den Keramikschichten (2) des Piezostapels (1) polarisiert wird.

6. Verfahren nach Anspruch 5, bei dem
die Keramik der Passivierung (7) eine geringere elektrische Koerzitivfeldstärke aufweist als das Material der Keramikschichten (2) des Piezostapels (1) und
der Passivierung (7) durchgehend eine Polarisation eingeprägt wird, wenn die Passivierung (7) zusammen mit den Keramikschichten (2) des Piezostapels (1) polarisiert wird.

7. Verfahren nach Anspruch 5 oder 6, bei dem die Keramik der Passivierung (7) so gewählt wird, dass sie bei Einprägen einer Polarisation stärker als der Piezostapel (1) gedehnt wird,
die Passivierung (7) mit dem Piezostapel (1) fest verbunden wird und
die Passivierung (7) in einer durch die alternierende Abfolge von piezoelektrischen Keramikschichten (2) und Innenelektroden (5, 6) definierten Längsrichtung (11) des Piezostapels (1) mit einer Druckspannung versehen wird, wenn die Passivierung (7) zusammen mit den Keramikschichten (2) des Piezostapels (1) polarisiert wird.

8. Verfahren nach einem der Ansprüche 5 bis 7, bei dem die Passivierung (7) in einer Dicke hergestellt wird, die größer ist als das Eineinhalbfache der Dicke einer einzelnen der Keramikschichten (2) des Piezostapels (1).

## Claims

1. Piezoelectric multilayer component comprising
- a piezo-stack (1) having an alternating sequence of piezoelectric ceramic layers (2) and internal electrodes (5, 6), and
- a passivation (7) on an outer side of the piezo-stack (1), where the material of the passivation (7) is a piezoelectric ceramic and is different from the material of the ceramic layers (2) of the piezo-stack (1),
**characterized in that**
- the ceramic of the passivation (7) has a lower electric coercive field strength than the ceramic layers (2) of the piezo-stack (1) or is constituted such that it is expanded to a greater extent by impression of a polarization than the material of the ceramic layers (2) of the piezo-stack (1).

2. Piezoelectric multilayer component according to Claim 1, wherein the passivation (7) is polarized continuously.

3. Piezoelectric multilayer component according to either of Claims 1 and 2, wherein
the passivation (7) has a compressive stress in a longitudinal direction (11) of the piezo-stack (1), said longitudinal direction being defined by the sequence of ceramic layers (2) and internal electrodes (5, 6), which compressive stress is maintained on account of a fixed connection of the passivation (7) to the piezo-stack (1) and at least partly compensates for a tensile stress exerted on the passivation (7) in the case of an expansion of the piezo-stack (1) in the longitudinal direction (11).

4. Piezoelectric multilayer component according to any of Claims 1 to 3, wherein
the passivation (7) has a thickness which is greater than one and a half times the thickness of an individual one of the ceramic layers (2) of the piezo-stack (1).

5. Method for producing a piezoelectric multilayer component according to any of Claims 1 to 4, wherein
- a piezo-stack (1) having an alternating sequence of piezoelectric ceramic layers (2) and internal electrodes (5, 6) is provided with a passivation (7) comprising a piezoelectric ceramic which is different from the material of the ceramic layers (2) of the piezo-stack (1), and
- the passivation (7) is polarized together with the ceramic layers (2) of the piezo-stack (1).

6. Method according to Claim 5, wherein the ceramic of the passivation (7) has a lower electric coercive field strength than the material of the ceramic layers (2) of the piezo-stack (1), and a polarization is impressed continuously on the passivation (7) when the passivation (7) is polarized together with the ceramic layers (2) of the piezo-stack (1).

7. Method according to Claim 5 or 6, wherein
the ceramic of the passivation (7) is chosen such that it is expanded to a greater extent than the piezo-stack (1) when a polarization is impressed,
the passivation (7) is fixedly connected to the piezo-stack (1), and
the passivation (7) is provided with a compressive stress in a longitudinal direction (11) of the piezo-stack (1), said longitudinal direction being defined by the alternating sequence of piezoelectric ceramic layers (2) and internal electrodes (5, 6), when the passivation (7) is polarized together with the ceramic layers (2) of the piezo-stack (1).

8. Method according to any of Claims 5 to 7, wherein the passivation (7) is produced with a thickness which is greater than one and a half times the thickness of an individual one of the ceramic layers (2) of the piezo-stack (1).

## Revendications

1. Composant piézoélectrique multicouche comportant
- un empilement piézoélectrique (1) qui comporte une séquence alternée de couches céramiques piézoélectriques (2) et d'électrodes internes (5, 6), et
- une passivation (7) sur une face extérieure de l'empilement piézoélectrique (1), dans lequel le matériau de la passivation (7) est une céramique piézoélectrique et est différent du matériau des couches céramiques (2) de l'empilement piézoélectrique (1),
**caractérisé en ce que**
- la céramique de la passivation (7) présente une plus faible force coercitive électrique que les couches céramiques (2) de l'empilement piézoélectrique (1) ou est configurée de manière à ce qu'elle soit plus fortement dilatée par application d'une polarisation que le matériau des couches céramiques (2) de l'empilement piézoélectrique (1).

2. Composant piézoélectrique multicouche selon la revendication 1, dans lequel la passivation (7) est polarisée en continu.

3. Composant piézoélectrique multicouche selon l'une
quelconque des revendications 1 ou 2, dans lequel la passivation (7) présente une contrainte de compression
dans une direction longitudinale (11) définie par la séquence de couches céramiques (2) et d'électrodes internes (5, 6) de l'empilement piézoélectrique (1), qui est conservée en raison du fait que la passivation (7) est fermement reliée à l'empilement piézoélectrique (1) et compense au moins partiellement un effort de traction exercé sur la passivation (7) dans la direction longitudinale (11) lors d'une dilatation de l'empilement piézoélectrique (1).

4. Composant piézoélectrique multicouche selon l'une
quelconque des revendications 1 à 3, dans lequel la passivation (7) présente une épaisseur qui est supérieure
à une fois et demie l'épaisseur de l'une, individuelle, des couches céramiques (2) de l'empilement piézoélectrique (1).

5. Procédé de réalisation d'un composant multicouche piézoélectrique selon l'une quelconque des revendications 1 à 4, dans lequel
- un empilement piézoélectrique (1) qui comporte une séquence alternée de couches céramiques piézoélectriques (2) et d'électrodes internes (5, 6), est muni d'une passivation (7) qui comporte une céramique piézoélectrique différente du matériau des couches céramiques (2) de l'empilement piézoélectrique (1), et
- la passivation (7) est polarisée en association avec les couches céramiques (2) de l'empilement piézoélectrique (1).

6. Procédé selon la revendication 5, dans lequel la céramique de la passivation (7) présente une plus faible
force coercitive électrique que le matériau des couches céramiques (2) de l'empilement piézoélectrique (1) et dans lequel une polarisation est appliquée en continu à la passivation (7) lorsque la passivation (7) est polarisée en association avec les couches céramiques (2) de l'empilement piézoélectrique (1).

7. Procédé selon la revendication 5 ou 6, dans lequel
la céramique de la passivation (7) est sélectionnée de manière à ce qu'elle soit dilatée plus fortement que l'empilement piézoélectrique (1) lors de l'application d'une polarisation,
la passivation (7) est solidement reliée à l'empilement piézoélectrique (1) et
la passivation (7) est soumise à une contrainte de compression dans une direction longitudinale (11) de l'empilement piézoélectrique (1) définie par la séquence alternée de couches céramiques piézoélectriques (2) et d'électrodes internes (5, 6) lorsque la passivation (7) est polarisée en association avec les couches céramiques (2) de l'empilement piézoélectrique (1).

8. Procédé selon l'une quelconque des revendications 5 à 7, dans lequel la passivation (7) est réalisée sur une épaisseur qui est supérieure à une fois et demie l'épaisseur de l'une, individuelle, des couches céramiques (2) de l'empilement piézoélectrique (1).
